# EUROPEAN PATENT SPECIFICATION

(11) **EP 1 965 451 B1**
(45) Date of publication and mention of the grant of the patent: **10.08.2016**
(21) Application number: 07116657.3
(22) Date of filing: 18.09.2007
(51) Int. Cl.: H01L 51/00, H01B 1/12, C08K 3/04, C08L 65/00

(54) **Dispersant for carbon nanotubes and carbon nanotube comosition comprising the same**
Dispersionsmittel für Kohlenstoff-Nanoröhrchen und Kohlenstoff-Nanoröhrchen-Zusammensetzung damit
Dispersant pour nanotubes en carbone et composition à nanotubes en carbone le comprenant

(30) Priority: 27.02.2007 KR 20070019534; 30.05.2007 KR 20070052574
(43) Date of publication of application: 03.09.2008
(73) Proprietor: Samsung Electronics Co., Ltd., Suwon-si, Gyeonggi-do, 443-742 (KR)
(72) Inventor: Choi, Jae Young, Gyeonggi-do (KR); Choi, Seong Jae, Gyeonggi-do (KR); Shin, Hyeon Jin, Gyeonggi-do (KR); Yoon, Seon Mi, Gyeonggi-do (KR)
(74) Representative: Zijlstra, Robert Wiebo Johan

(56) References cited:
- JP-A- 2004 339 301
- JP-A- 2006 248 888
- US-A1- 2006 118 768
- STEUERMAN D W ET AL: "INTERACTIONS BETWEEN CONJUGATED POLYMERS AND SINGLE-WALLED CARBON NANOTUBES" JOURNAL OF PHYSICAL CHEMISTRY. B, MATERIALS, SURFACES, INTERFACES AND BIOPHYSICAL, WASHINGTON, DC, US, vol. 106, no. 12, 28 March 2002 (2002-03-28), pages 3124-3130, XP008043689 ISSN: 1089-5647
- LIU ET AL: "Endgroup Modification of regioregular Polythiophene through Postpolymerization Functionalization" MACROMOLECULES, ACS, WASHINGTON, DC, US, vol. 35, 1 January 2002 (2002-01-01), pages 9882-9889, XP002418290 ISSN: 0024-9297

## Description

The present disclosure relates to a dispersant for carbon nanotubes. In particular, this disclosure relates to a dispersant that promotes excellent dispersion of carbon nanotubes in a composition.

Carbon nanotubes (CNT) are tubular molecules in which one carbon atom is bonded with other carbon atoms in a honeycomb arrangement. Carbon nanotubes generally can have a single wall (single wall carbon nanotubes) or multiple walls (multiwall). Single wall carbon nanotubes have diameters of 0.7 to 3 nanometers, while multiwall carbon nanotubes have diameters of 3.5 to 500 nanometers. Carbon nanotubes generally have aspect ratios of 5 to 10,000. Single wall carbon nanotubes generally exist in the form of ropes due to Vander Waals forces. Carbon nanotubes also exist in the form of bundles called aggregates.

Carbon nanotubes have excellent mechanical properties, high electrical selectivity, excellent field emission properties, and high-efficiency hydrogen storage medium characteristics. Further, carbon nanotubes can exhibit either semiconducting or metallic properties. These various types of carbon nanotubes have different energy gaps and exhibit a peculiar quantum effect because they have a quasi-one-dimensional structure.

Various methods can be used to produce carbon nanotubes such as an electric discharge method, a pyrolysis method, a laser deposition method, a plasma chemical vapor deposition method, a thermal chemical vapor deposition method and an electrolysis method.

Further, since carbon nanotubes have high electrical conductivity, they are used for forming conductive films, and the likelihood that carbon nanotubes will be used in various functional complexes, such as probes of a field emission display (FED) and a scanning probe microscope (SPM), or the like, in the future is increasing. Accordingly, research on carbon nanotubes is increasing feverishly.

Meanwhile, in order to form a conductive film using carbon nanotubes or to apply carbon nanotubes to functional complexes, it is desired that the carbon nanotubes be dispersed in a suitable dispersion medium. However, since carbon nanotubes have a very large surface attractive forces, such as the van der Waals force, which is the force between molecules, carbon nanotube particles easily aggregate with each other to form ropes. This aggregation phenomenon hinders the formation of a three-dimensional structure, which can improve the mechanical strength and conductivity thereof. Accordingly, in order to increase the applicability of carbon nanotubes, technologies for dispersing carbon nanotubes using a suitable dispersant are desired. However, currently, the application of carbon nanotubes is limited due to the ineffectiveness of these dispersion technologies.

A dispersant, which is a kind of surfactant, includes a head and a tail. Here, it is desirable for the head to have an affinity for a dispersoid (e.g., the nanotubes), which is the material to be dispersed, and it is desirable for the tail to have an affinity for a dispersion medium, which is a solvent for dispersing materials. Moreover, it is desirable for a good dispersant to also serve as a barrier for the collision between particles.

Water-based dispersants, such as sodium dodecyl benzene sulfonate (NaDDBS), sodium dodecyl sulfonate, TX-100, polyvinyl pyrrolidone and the like, are used as conventional dispersants for carbon nanotubes. However, there is a problem in that water-based dispersants can easily disperse carbon nanotubes only in water, but cannot effect the dispersing of the carbon nanotubes in an organic solvent.

Further, organic dispersants are not widely known yet. However, Korean Unexamined Application Publication No. 2004-0039425 and Japanese Unexamined Application Publication No. 2004-339301 have disclosed the fact that carbon nanotubes can be easily dispersed in an organic solvent using a polythiophene conjugated polymer. However, the use of a polythiophene polymer has drawbacks, not the least of which is the lack of control over the molecular weight of the polythiophene. The lack of control over the molecular weight causes limited dispersion of the carbon nanotubes in only two or three types of media.

Japanese patent application JP 2006-248888 discloses a method of manufacturing a carbon nanotube of micron length by cooling a mixture comprising a liquid and the carbon nanotube to a temperature equal to and below the freezing point of the liquid and pulverizing the solidified material.

Japanese patent application JP 2004-339301 discloses an anisotropic polymer composite membrane composed of a conjugated polymer in which carbon nanotubes are dispersed.

US patent application US 2006/118768 discloses a thin film device and compound having an anode, a cathode, and at least one light emitting layer between the anode and cathode, the at least one light emitting layer having at least one carbon nanotube and a conductive polymer.

D.W. Steuermann et al. in J. Phys. Chem. B, 2002, 106 pages 3124-3130 describe the chemical interactions between single walled carbon nanotubes and two structurally similar polymers, pmPV and PPyPV. Both polymers promote the solubilization of the carbon nanotubes in chloroform.

J.Liu et al. in Macromoelcules, 2002, 35, pages 9882-9889 disclose the end group modification of a regioregular polythiophene through post-polymerization functionalisation with -OH and -NH₂ groups.

Accordingly, it is desirable to have a dispersant to disperse carbon nanotubes in various solvents, including organic solvents, water-based solvents, and mixtures thereof.

Accordingly, in one embodiment, a dispersant for carbon nanotubes according to claim 1 is provided. The dispersant can improve the dispersion of carbon nanotubes by controlling the structural properties of the dispersant.

In another embodiment, a carbon nanotube composition comprises a dispersant having a structure that can improve the dispersion of carbon nanotubes.

In yet another embodiment, a dispersant for carbon nanotubes comprises heads and tails, in which the tails are regioregularly arranged.

In yet another embodiment, it is preferred that the ratio of heads to tails be 1 or more.

In yet another embodiment, a carbon nanotube composition comprises a dispersant having the aforementioned structure, carbon nanotubes, and a dispersion medium selected from the group consisting of an organic solvent, water, and a mixture thereof.

The composition may include 0.001 to 10 wt% (weight percent) of a dispersant, 0.01 to 5 wt% of carbon nanotubes, and a balance of dispersion medium, based on the total weight of the composition.

The above and other features and advantages will be more clearly understood from the following detailed description taken in conjunction with the accompanying drawings, in which:
FIGS. 1A to 1C are schematic views showing the various structures of dispersants according to an embodiment;
FIG. 2 is a schematic view showing the state in which carbon nanotubes are dispersed by a dispersant according to an embodiment;
FIG. 3A is a graph showing the UV-Vis-NIR Spectroscopy characteristic curves of a carbon nanotube solution based on the structure (regioregularity) of a dispersant;
FIG. 3B is a dispersity evaluation graph using the UV-Vis-NIR Spectroscopy characteristic curves;
FIG. 4A is a graph showing the UV-Vis-NIR Spectroscopy characteristic curves of a carbon nanotube solution based on the structure (the ratio of heads to tails) of a dispersant; and
FIG. 4B is a dispersity evaluation graph using the UV-Vis-NIR Spectroscopy characteristic curves.

Hereinafter, the structure of a dispersant for carbon nanotubes will be described in detail with reference to the attached drawings.

In the design of a dispersant for dispersing carbon nanotubes, it is desirable for (a) the heads of a dispersant to adhere to the hydrophobic surface of carbon nanotubes, (b) the tails of a dispersant to facilitate dissolution in a solvent. It is desirable for the dispersant to have a density high enough to prevent the aggregation of carbon nanotubes when carbon nanotubes are in a position to contact one another.

The structure of a dispersant for carbon nanotubes is characterized in that the structural properties thereof are controlled such that tails are regioregularly arranged.

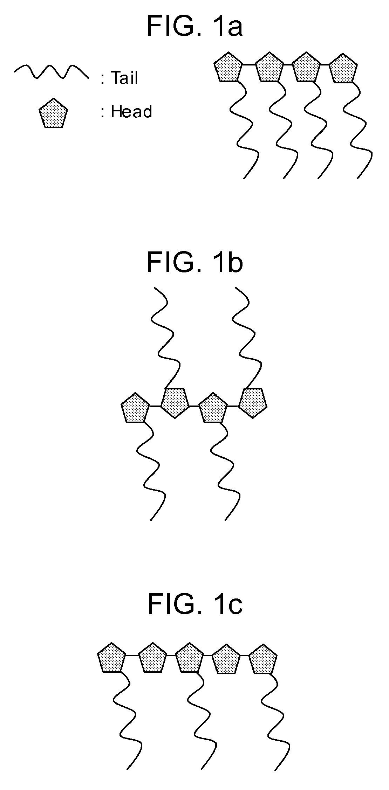

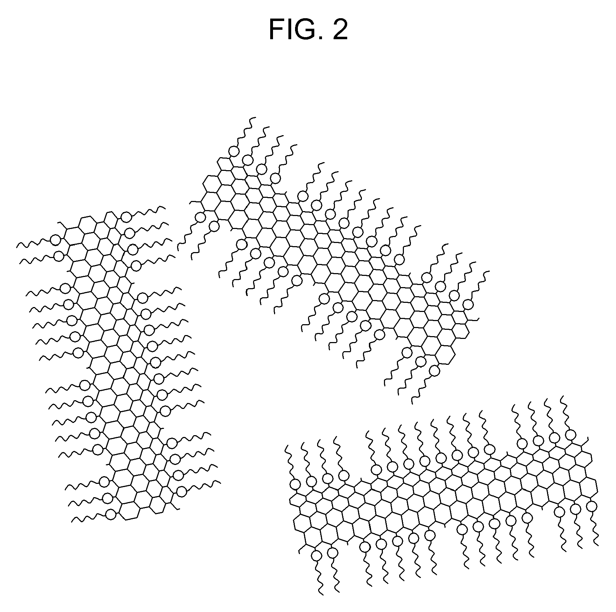

As shown in FIG. 1A to 1C, since the dispersant has a structure (FIG. 1A) in which heads are regularly arranged and carbon nanotubes also have a structure in which atoms are regularly arranged, the dispersant is more effectively adsorbed on the carbon nanotubes than a conventional dispersant having a structure (FIG. 1B) in which heads and tails are irregularly arranged, thereby decreasing dispersion efficiency. FIG. 2 schematically shows the state in which carbon nanotubes are dispersed by a dispersant according to an embodiment.

Further, the dispersant for carbon nanotube is characterized in that the dispersion efficiency of the dispersant is improved by controlling the ratio of heads to tails. In this case, it is preferred that the ratio of heads to tails be 1 or more.

In a dispersant, the ratio of heads to tails is the ratio of the number of heads to the number of tails. Here, if the number of heads is greater than the number of tails, the adsorption function effected by the heads is strengthened relative to the dispersion function that is effected by the tails. In contrast, if the number of heads is lower than the number of tails, the dispersion function effected by the tails is strengthened relative to the adsorption function that is effected by the heads.

More specifically, the conditions for optimizing the dispersion of carbon nanotubes is as follows: 1) when carbon nanotubes collide with one another and aggregate with each other, it is desirable for the heads of the dispersant to continue to be attached to the surface of the carbon nanotubes, and 2) it is desirable for the tails of the dispersant to have a high density per unit surface area of the carbon nanotubes, such that they have sufficient repulsive force that acts against the attractive force between the carbon nanotubes. Accordingly, in order to maximize dispersion using the given carbon nanotubes and dispersant, it is desirable to control the ratio of heads to tails. That is, when the ratio of heads to tails is increased, compared to the case where this ratio is 1, the adsorptive force of the heads with the carbon nanotubes is increased, but the repulsive force of the tails is decreased. Therefore, when the given carbon nanotubes are dispersed using a predetermined dispersant, an optimum ratio is desirable depending on the adsorptive force between the carbon nanotubes and the dispersant and on the repulsive force between the tails. With regard to carbon nanotubes, since the heads of the dispersant have low adsorptivity, it is desirable to increase the ratio of heads to tails so that the adsorptive force between the carbon nanotubes and the heads of the dispersant is increased, thereby improving the dispersibility of the carbon nanotubes. However, when the ratio of heads to tails is increased above a critical value, the repulsive force of the tails is decreased due to the decrease in the density of the tails, and thus an optimum ratio of heads to tails is maintained.

It is preferred that the heads of the dispersant, as represented by the following formula 1, be formed of atoms having many electrons, such as sulfur, nitrogen and the like, and aromatic rings, which have a high affinity for the carbon in the carbon nanotubes. 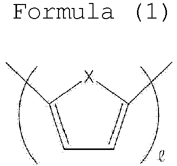 wherein X is S, NH or O, and L is an integer of 1 to 60.

Accordingly, the heads can easily donate electrons to carbon nanotubes, can form a π -π coupling between the carbon nanotubes and the electrons, and can be adsorbed on the carbon nanotubes in an arrangement in which the carbon nanotubes are wrapped in comb structures, as shown in FIG. 2, thereby making it easy to disperse the carbon nanotubes in any dispersion medium.

It is preferred that the tails connected with the heads have the structure represented by the following formula (2), such that the tails have high affinity both for organic solvents, containing carbon (C), hydrogen (H) and the like, and for water-based solvents.

Formula (2) (̵YOₐ)̵ₘ-(CH₂)ₙ-Z

wherein Y is selected from the group consisting of a substituted or unsubstituted alkylene group of 1 to 10 carbon atoms, a substituted or unsubstituted alkenylene group of 1 to 10 carbon atoms, a substituted or unsubstituted alkynylene group of 1 to 10 carbon atoms, and a substituted or unsubstituted arylalkylene group of 6 to 20 carbon atoms, Z is selected from the group consisting of -H, -CH₃, -OH, carboxyl acid or salts thereof, sulfonic acid or salts thereof, and phosphoric acid or salts thereof, a is 0 or 1, m is an integer of 1 to 9, and n is an integer of 0 to 9.

Accordingly, the dispersant, which includes the tails, makes it easy to disperse carbon nanotubes in various dispersion media including an organic solvent, water, a mixture of two or more organic solvents, a mixture of one or more polar solvents and water, and the like.

The tails serve to prevent the collision and aggregation between carbon nanotube particles because they spread out in all directions from the heads and thus cause a steric hindrance effect and electrostatic repulsion.

In the formula (2), when a is 0, the hydrophobicity is increased and carbon nanotubes are easily dispersed in organic solvents. In contrast, when a is 1, the hydrophilicity is increased and carbon nanotubes are easily dispersed in polar solvents, water, or a mixture thereof. In this case, this dispersion effect is due to the steric hindrance effect.

Moreover, when carboxyl acid or a salt thereof, sulfonic acid or a salt thereof, or phosphoric acid or a salt thereof is introduced into Z, since electrostatic repulsion can be induced, carbon nanotubes can be more effectively dispersed in polar solvents, water, or the like, or a mixture thereof.

Meanwhile, in the formula (2), specifically, the unsubstituted alkylene group of 1 to 10 carbon atoms may include methylene, ethylene, propylene, iso-butylene, sec-butylene, pentylene, iso-amylene, hexylene and the like. Further, one or more hydrogen atoms of the alkylene group may be substituted with a halogen atom, a hydroxyl group, a nitro group, a cyano group, an amino group, an amidino group, hydrazine, hydrazone, carboxyl acid or salts thereof, sulfonic acid or salts thereof, or phosphoric acid or salts thereof.

The unsubstituted alkenylene or alkynylene group of 1 to 10 carbon atoms has a carbon double bond or a carbon triple bond at the middle or end portion of the alkylene group. Specifically, the unsubstituted alkenylene or alkynylene group may include ethylene, propylene, butylene, hexylene, acetylene, and the like. Further, one or more hydrogen atoms of the unsubstituted alkenylene or alkynylene group may be substituted with a halogen atom, a hydroxyl group, a nitro group, a cyano group, an amino group, an amidino group, hydrazine, hydrazone, carboxyl acid or salts thereof, sulfonic acid or salts thereof, or phosphoric acid or salts thereof.

In the arylalkylene group, some of the hydrogen atoms in an arylene group, which is a carbocycle aromatic system of 6 to 20 carbon atoms including one or more rings, are substituted with radicals such as methylene, ethylene, propylene and the like. Examples of the arylalkylene group are a benzylene group, a phenylethylene group, and the like. One or more hydrogen atoms of the arylalkylene group may be substituted with a halogen atom, a hydroxyl group, a nitro group, a cyano group, an amino group, an amidino group, hydrazine, hydrazone, carboxyl acid or salts thereof, sulfonic acid or salts thereof, or phosphoric acid or salts thereof.

In the present invention, it is preferred that the tail be a polyethyleneoxide of 3 to 20 carbon atoms, but it is not limited thereto.

Hereinafter, a carbon nanotube composition containing a dispersant will be described.

A carbon nanotube composition includes a dispersant having the aforementioned structure; carbon nanotubes; and an organic solvent, water, or a mixture thereof.

The carbon nanotube composition includes 0.001 to 10 wt% of the dispersant; 0.01 to 5 wt% of carbon nanotubes; and a balance of dispersion medium, based on the total weight of the composition.

In this case, it is preferred that the weight ratio of the carbon nanotube to the dispersant is in an amount of 1:0.001 to 1:10. The reason is that, when the amount of the the dispersant is excessively small, appropriate dispersion of nanotubes cannot be obtained, and in contrast, when the amount of the dispersant is excessively large, there is a negative effect on the dispersion of carbon nanotubes.

The carbon nanotube, can be selected from the group consisting of a single-walled nanotube, a double-walled nanotube, a multi-walled nanotube and a bundled nanotube.

The dispersion medium can comprise organic polar solvents, organic non-polar solvents, or a combination comprising at least one of the foregoing solvents.

The dispersion medium, which can be used in the present invention, can comprise an organic solvent, water, a mixture of two or more organic solvents, and a mixture of one or more polar solvents and water, but is not limited thereto.

In this case, the organic solvent may be one or more selected from the group consisting of alcohols, including methylalcohol, ethylalcohol, n-propylalcohol, isopropylalcohol, n-butylalcohol, sec-butylalcohol, t-butylalcohol, iso-butylalcohol, and diacetone alcohol; ketones including acetone, methylethylketone, and methylisobutylketone; glycols including ethyleneglycol, diethyleneglycol, triethyleneglycol, propyleneglycol, butyleneglycol, hexyleneglycol, 1,3-propanediol, 1,4-butanediol, 1,2,4-butanetriol, 1,5-pentanediol, 1,2-hexanediol, and 1,6-hexanediol; glycol ethers including ethyleneglycol monomethyl ether, and triethyleneglycol monoethyl ether; glycol ether acetates including propyleneglycol monomethyl ether acetate (PGMEA); acetates including ethylacetate, butoxyethoxy ethyl acetate, butyl carbitol acetate (BCA), and dihydroterpineol acetate (DHTA); terpineols; trimethyl pentanediol monoisobutyrate (TEXANOL); dichloroethene (DCE); and 1-methyl pyrrolidone (NMP).

Meanwhile, the composition, if desired, may further include one or more additives selected from the group consisting of an organic binder, a photosensitive monomer, a photoinitiator, a viscosity modifier, a storage stabilizer, a wetting agent, and an acid or a base within a range in which the material properties of the composition are maintained.

In this case, the amount of the additive may be 0.1 to 60 parts by weight, based on 100 parts by weight of the composition.

The organic binder, which can be used in the present invention, can comprise celluloses including ethylcellulose, styrenes, a styrene-acrylic acid ester copolymer, polyvinylbutyral, polyvinylalcohol, and polypropylene carbonate, and the like. It is preferred that a cellulose binder composed of ethylcellulose or a mixture thereof be used.

Any common photosensitive monomers and photoinitiators can be used as the photosensitive monomer and photoinitiator. Specifically, the photosensitive monomer can include a thermally-degradable acrylate monomer, a benzophenone monomer, an acetophenone monomer, a thiokisantone monomer, and the like.

Any common viscosity modifiers and storage stabilizers can also be used. Specifically, the viscosity modifier may include casein, carboxymethyl cellulose, and the like.

Further, wetting agents can also be used. Specifically, polyvalent alcohols, including glycerin, ethylene glycol, diethylene glycol, triethylene glycol, propylene glycol, dipropylene glycol, 1,3-butanediol, 1,4- butanediol, 1,5-pentanediol, 1,2-hexanediol, 2-methyl-2-pentanediol and the like, may be used as the wetting agent.

The composition may further include an acid or a base. The acid or base serves to increase the solubility of a dispersant in the solvent, and serves to stabilize the dispersion of the carbon nanotubes by imparting an electrostatic repulsive force to the dispersed carbon nanotube particles. Here, hydrochloric acid, sulfuric acid, nitric acid, acetic acid, carbonic acid, and the like, may be used as the acid, and sodium hydroxide, potassium hydroxide, calcium hydroxide, ammonium hydroxide, and the like, may be used as the base.

The composition comprising the dispersant, the carbon nanotubes, the solvent along with desired additives and resins can be blended together to form a uniform isotropic composition. The blending can be melt or solution blending. Blending is generally conducted in a device where shear, elongational and extensional forces are simultaneously or sequentially applied. An exemplary blender is an extruder such as a single or twin screw extruder, a buss kneader, a Henschel mixer or a Waring blender.

The composition can be applied to various industrial fields in which aqueous or oily carbon nanotube compositions can be used. Specifically, the composition can be used for producing an emitter of a field emission display (FED), a carbon nanotube ink, or a printable carbon nanotube.

Hereinafter, preferred embodiments will be described in detail with reference to Examples. Here, these Examples are set forth to illustrate the present invention, but should not to be construed as the limitations of the present invention.

First, in order to evaluate the dispersion ability of a dispersant having a structure according to the present invention, six dispersants having structural properties different from each other were provided, as shown in the following Table 1. Hereinafter, the six dispersants will be described in detail.

**Table 1**

| Sample name | | Structure | Regio-regularity | Head/Tail |
|---|---|---|---|---|
| 3-Hexylthiophene | | 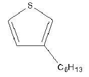 | | 1 |
| | H_{6, RR} | 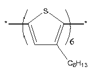 | Regioregular | 1 |
| | H_{12, RR} | 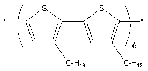 | Regioregular | 1 |
| Designed thiophene | H_{12, RRa} | 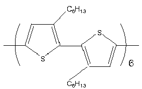 | Regiorandom | 1 |
| | H_{12, RRa} (*H*/*T*=*2*) | 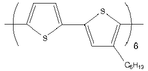 | Regiorandom | 2 |
| | H_{12, RRa} (*H*/*T*=*3*) | 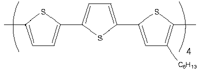 | Regiorandom | 3 |

| | | | | |
|---|---|---|---|---|
| *In H _{6,12, RR, RRa}, of Table 1, | | | | |

6 indicates that it has six aromatic rings, 12 indicates that it has twelve aromatic rings, RR represents regioregular, and RRa represents regiorandom.

### Preparation Example 1: Synthesis of dispersant 2 and dispersant 3 (regioregular)

The polymerization of a dispersant having a regioregular structure, in which head and tails are arranged in one direction, was performed using a nickel (Ni) catalyst as follows.

First, 1.48g (61.32mmol) of Mg (magnesium) and 100mL of THF (tetrahydrofuran) were put into a reactor. Subsequently, I₂ (iodine) was added thereto while heating the reactor, 20g (61.32mmol) of 2,5-dibromo-3-hexylthiophene was slowly added thereto, and the mixture was then refluxed until the Mg had completely melted. Next, 0.96g (1.83mmol) of NiCl₂(dppp) (nickel chloride) was added thereto and the mixture was then refluxed for 5 hours to form a reaction product. After the reaction was completed, the reaction product was cooled to room temperature, and was then extracted by removing the solvent therefrom and dissolving it in EDC. The solid that was not dissolved in the EDC was filtered to form a solution, and the solvent was removed from the solution using an evaporator, and the solid was then dried in a vacuum, thereby obtaining a red solid. The obtained red solid was extracted through a solvent extraction method, thereby preparing a dispersant 2 and a dispersant 3 depending on molecular weight.

### Preparation Example 2: Synthesis of dispersant 4 (Regiorandom)

The polymerization of a dispersant having a regiorandom structure, in which heads and tails are irregularly arranged, was performed using a FeCl₃ (iron chloride) catalyst as follows.

First, 19.27g (118.83mmol) of FeCl₃ and 100mL of CHCl₃ (chloroform) were put into a reactor in an argon atmosphere, and were then cooled to a temperature of 0°C. Subsequently, 5g (29.70mmol) of 3-hexylthiophene was slowly added to the reactor, and the mixture was then stirred at the same temperature for 30 minutes to form a reaction product. After the reaction was completed, the reaction product was put in 800mL of methanol, and the mixture was then stirred for 1 hour to form a solid in a methanol solution. Next, the solid formed in the methanol solution was filtered. Then, the filtered solid was put in 200mL of a 30% ammonium chloride solution, stirred for about 1 hour, and then extracted using EDC. The solid that was not dissolved in the EDC was filtered to form a solution, and the solvent was removed from the solution using an evaporator, and was then dried in vacuum, thereby obtaining a red solid (a dispersant 4).

### Preparation Example 3: Synthesis of dispersant 5 (head/tail=2)

A dispersant 5 was synthesized through the processes shown in the following Table 2.

### First process: Synthesis of compound 1

3-bromothiophene (28 mL, 300 mmol) and NiCl₂(dppp) (0.8 g, 1.5 mmol) were dissolved in ether (250 mL), and then hexylmagnesium bromide, which is a compound obtained by reacting magnesium (8.75 g, 360 mmol) with hexyl bromide (49.5 g, 420 mmol) in ether (250 mL), was slowly added thereto at a temperature of 0°C. Subsequently, the mixed solution was heated to room temperature and was then refluxed to form a reaction product. After the reaction was completed, the reaction product was added with ammonium chloride (*aq*.), and was then extracted using ether. Next, the extracted reaction product was refined through a reduced-pressure distillation, thereby obtaining 41.0 g (244 mmol, 81%) of compound 1.
¹H NMR (δ, CDCl₃) : 7. 10 (d, 1 H), 6.88 (d, 1 H), 6.84 (s, 1 H), 2.58 (t, 2 H), 1.59 (m, 2 H), 1.26 (m, 8 H), 0.88 (m, 3.7 H).

### Second process: Synthesis of compound 2

Compound 1 (41 g, 244 mmol) was put in THF (500 mL) and cooled to a temperature of -20°C, and then *N,N,N,N-*tetramethyl-ethylenediamine (40.21 mL, 268 mmol) was added thereto. After 30 minutes, the mixed solution was cooled to a temperature of -78°C, and then n-BuLi (1.6 M in hexane, 160 mL) was added thereto, and the mixture was heated to room temperature and then refluxed for 3 hours. Next, the mixed solution was cooled to a temperature of -78°C again, and then 2-isopropoxy-4,4,5,5-tetramethyl-1,3,2-dioxabororane (60 mL, 293 mmol) was added thereto. Subsequently, the mixed solution was slowly heated to room temperature, and was then left at room temperature for one day. Next, the mixed solution was extracted using H₂O (water) and CH₂Cl₂ (dichloromethane), and was then separated using a silica gel column, thereby obtaining 50.3 g (171 mmol, 70%) of compound 2.
¹H NMR (δ, CDCl₃) : 7.46 (s, 1 H), 7.20 (s, 1 H), 2.61 (t, 2 H), 1.59 (m, 2 H), 1.30 (m, 22 H), 0.88 (t, 4 H).

### Third process: Synthesis of compound 3

Compound 3 was synthesized using the same method as in compound 1.

### Fourth process: synthesis of compound 4

Compound 3 (8 g, 48 mmol) was dissolved in chloroform (50 mL) and AcOH (acetic acid) (150 mL), and was then cooled to a temperature of 0°C. Subsequently, NBS (what is NBS?) (8.55 g, 48 mmol) was slowly added thereto in small amounts while light was blocked. Next, the mixed solution was quenched using Na₂SO₃ (sodium sulfite) (*aq*.) and then extracted using hexane. Finally, 7.4 g (30 mmol, 63%) of a white solid was obtained through a recrystallization method.

### Fifth process: Synthesis of compound 5

2-bromothiophene (5.3 g, 32 mmol), compound 2 (10.5 g, 35.5 mmol), K₂CO₃ (potassium carbonate) (10.09 g, 102 mmol), and Pd(PPh₃)₄ (3.9 g, 3.4 mmol) were put in dimethoxyethane (150 mL) and H₂O (100 mL), and were then refluxed. Subsequently, the mixed solution was supplied with ammonium chloride (*aq*.), was extracted using chloroform, and was then refined through a reduced-pressure distillation, thereby obtaining 6.1 g (24.4 mmol, 76%) of compound 5.
¹H NMR (δ, CDCl₃) : 7.10 (m, 2 H), 6.98 (d, 1 H), 6.93 (dd, 1 H), 6.73 (d, 1 H), 2.56 (t, 2 H), 1.59 (m, 2 H), 1.26 (m, 8 H), 0.88 (m, 4 H).

### Sixth process: synthesis of dispersant 5

Anhydrous FeCl₃ (11.7 g, 72 mmol) was put in chloroform (150 mL), and was then cooled to a temperature of 0°C. Subsequently, compound 5 (6 g, 24 mmol) was dissolved in chloroform (20 mL), and was slowly dropped into the FeCl₃ solution. After the reaction was completed, the mixed solution was precipitated by putting it in methyl alcohol. Subsequently, the precipitated mixture was filtered, and thus a solid was obtained, and then the obtained solid was put in NH₄OH (*aq*.) and stirred at room temperature. Here, in the case where the solid appeared red, the solid was filtered, was cleaned using methyl alcohol several times, and was then dried, obtaining 4 g of sample.

### Preparation Example 4: Synthesis of dispersant 6 (head/tail=3)

6 g of sample was obtained by synthesizing compound 6 (compound 6 was prepared using the same method as compound 5) in the following Table 2 using the same method as in the Preparation Example 3 in the sixth process.

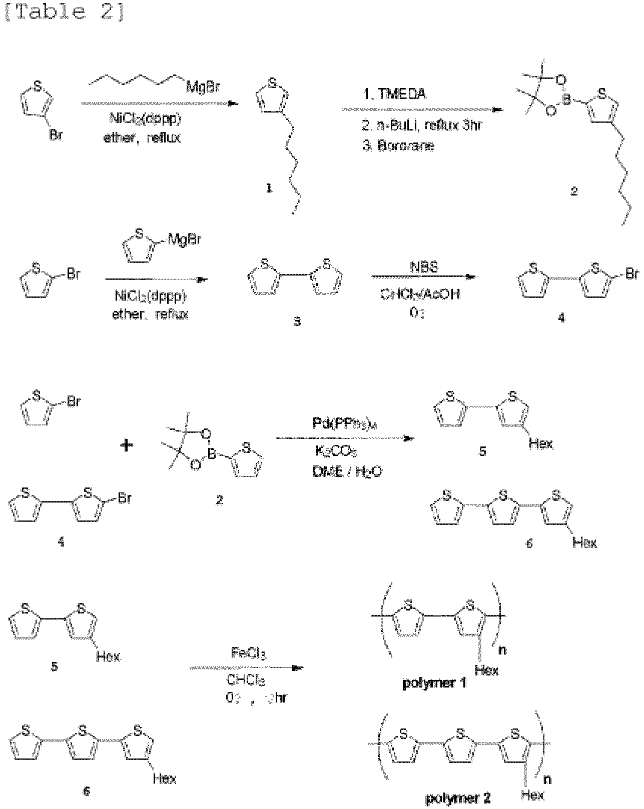

### [Measurement of dispersion of carbon nanotubes depending on the regioregularity of structure of dispersant]

### Reference Example 1.

2 mg of the dispersant was put into and dissolved in 20ml of NMP, and 2 mg of single-walled carbon nanotubes were added to this solution. Subsequently, the mixed solution was dispersed using a sonicator for 10 hours, and was then separated using a centrifugal machine at a speed of 8,000 rpm for 10 minutes, thereby obtaining a carbon nanotube solution.

### Reference Example 2

A carbon nanotube was obtained using the same method as in Reference Example 1, except that the dispersant 3 was used as a dispersant.

### Comparative Example 1

A carbon nanotube was obtained using the same method as in Reference Example 1, except that the dispersant 1 was used as a dispersant.

### Comparative Example 2

A carbon nanotube was obtained using the same method as in Reference Example 1, except that the dispersant 4 was used as a dispersant.

### Evaluation of dispersion efficiency

In the Examples and Comparative Examples, dispersion efficiency was evaluated using the following methods.

Generally, the dispersion of carbon nanotubes can be classified as a macrodispersion or a nanodispersion. Macrodispersion is a state in which the bundle of carbon nanotubes is not completely disentangled from the agglomerate, but is dispersed in a solvent. The macrodispersion can be evaluated by examining the absorbance of carbon nanotubes in the UV-Vis-IR spectrum. A high absorbance obtained in a UV-Vis-IR spectrum means that the carbon nanotubes are well dispersed.

In contrast, nanodispersion is a state in which the carbon nanotube strands are completely separated from the bundle of carbon nanotubes and are dispersed in a solution. The nanodispersion can be evaluated by evaluating the sharpness of the characteristic carbon nanotube peak, rather than the absorbance of carbon nanotubes, in the UV-Vis-IR spectrum. A sharp characteristic carbon nanotube peak means that the carbon nanotubes are well dispersed in the nano state.

In the present invention, the nano dispersity of the carbon nanotubes was evaluated by evaluating the main peak sharpness around 1006 nm, in which the E₁₁^{s} characteristics of carbon nanotubes are exhibited, using UV-Vis-NIR spectroscopy. The sharpness of peak can be determined using the ratio of height to width at the half maximum point of the peak. This method has been used by Resasco, et al., and can be used as a method of evaluating the nano dispersity of carbon nanotubes (J. Phys. Chem. B2005, 109, 14454).

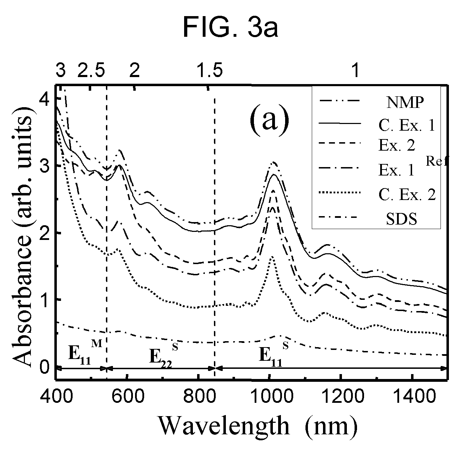

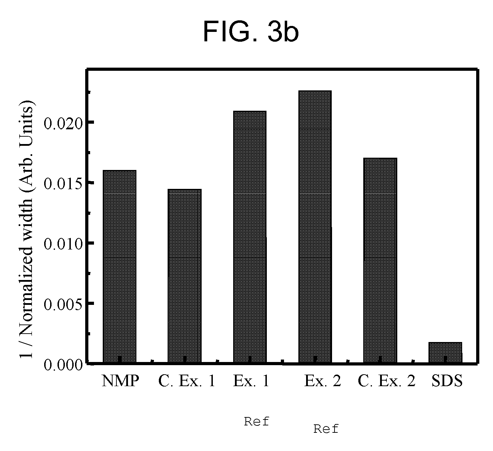

FIG. 3A and 3B show the dispersion efficiency related to the structural properties of a dispersant, which is evaluated using these measuring methods.

As shown in FIG. 3A and 3B, it can be seen that a regioregular structured dispersant (Reference Example 2) according to the present invention has better dispersion efficiency than a regiorandom structured dispersant (Comparative Example 2). Further, it can be seen that a polymer dispersant ( Reference Examples 1 and 2) has better dispersion efficiency than a monomer dispersant (Comparative Example 1), and, when using the same polymer dispersant, a high molecular weight dispersant (Reference Example 2) has better dispersion efficiency than a low molecular weight dispersant ( Reference Example 1).

In FIG. 3A and 3B, the data represented by NMP (N-methyl pyrrolidone) reflect the case where carbon nanotubes are dispersed using only an NMP solvent, which is the solvent used in the present invention, without the use of a dispersant, and the data represented by SDS reflect the case where carbon nanotubes are dispersed in NMP using SDS, which is known to be a very effective dispersant in the conventional art. Here, it can be seen that the dispersant according to the present invention exhibits much better characteristics than in the case where no dispersant is used (NMP) and in the case where the conventional dispersant (SDS) is used.

### [Measurement of dispersion of carbon nanotubes depending on the ratio of heads to tails of structure of dispersant]

### Reference Example 3

A carbon nanotube was obtained using the same method as in Reference Example 1, except that the dispersant 5 was used as a dispersant.

### Reference Example 4

A carbon nanotube was obtained using the same method as in Reference Example 1, except that the dispersant 6 was used as a dispersant.

### Evaluation of dispersion efficiency

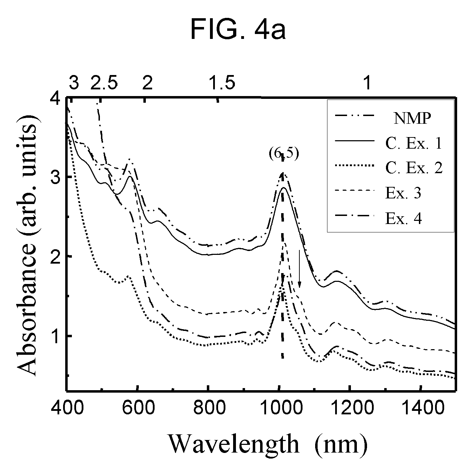

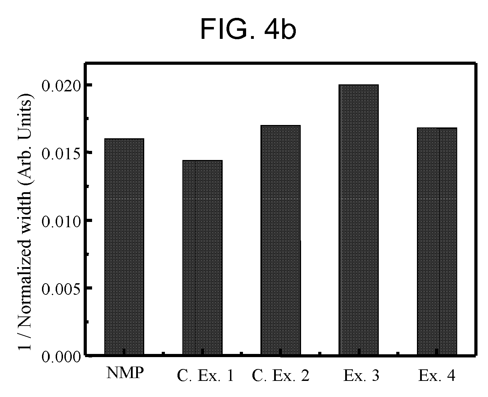

FIG. 4A and 4B show the dispersion efficiency in Examples 3 to 4 and Comparative Examples 3 to 4, evaluated using the same method as in Reference Examples 1 to 2 and Comparative Examples 1 to 2.

As shown in FIG. 4A and 4B, it can be seen that the dispersion efficiency of a dispersant depending on the control of the ratio of heads to tails is best in the case where the ratio of heads to tails is 2 (Reference Example 3).

As described above, when the tails of the dispersant are regioregularly arranged, and the structural properties of the dispersant are controlled such that the ratio of heads to tails is 1 or more, there is an effective stabilizing and dispersing of carbon nanotubes in various dispersion media, such as an organic solvent, water, a mixture thereof and the like, compared to conventional dispersants.

Accordingly, when the dispersant is used, there is an advantage in that carbon nanotube compositions such as those used in various industrial fields for producing emitters for field emission displays (FEDs), carbon nanotube ink, and printable carbon nanotubes can be easily produced.

As described above the preferred embodiments have been disclosed for illustrative purposes.

## Claims

1. A dispersant for carbon nanotubes, comprising:
a head covalently bonded to a tail;
the head having an aromatic ring; wherein the tails are regioregularly arranged, and wherein the head is selected from the group represented by the following Formula (1), and the tail is selected from the group represented by the following Formula (2): 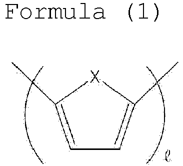 wherein
X is S, NH, or O, and
ℓ is an integer of 1 to 60,
Formula (2) (̵YOₐ)̵ₘ-(CH₂)ₙ-Z
wherein Y is selected from the group consisting of a substituted or unsubstituted alkylene group of 1 to 10 carbon atoms, a substituted or unsubstituted alkenylene group of 1 to 10 carbon atoms, a substituted or unsubstituted alkynylene group of 1 to 10 carbon atoms, and a substituted or unsubstituted arylalkylene group of 6 to 20 carbon atoms,
Z is selected from the group consisting of -H, -CH₃, -OH, carboxyl acid or salts thereof, sulfonic acid or salts thereof, and phosphoric acid or salts thereof,
a is 0 or 1,
m is an integer of 1 to 9, and
n is an integer of up to 9,
wherein the ratio of the number of heads to the number of tails in the dispersant is 2 to 3.

2. The dispersant according to claim 1, wherein, in the Formula (1), X is S.

3. The dispersant according to claim 1 or 2, wherein, in the Formula (1), ℓ is an integer of 10 to 20.

4. The dispersant according to any of claims 1 to 3, wherein the tail is polyethyleneoxide having 3 to 20 carbon atoms or polypropyleneoxide of 4 to 20 carbon atoms.

5. A carbon nanotube composition, comprising:
the dispersant of any of claims 1 to 4;
carbon nanotubes; and
a dispersion medium selected from the group consisting of an organic solvent, water, and a mixture thereof.

6. The carbon nanotube composition according to claim 5, wherein the composition comprises 0.001 to 10 wt% of a dispersant; 0.01 to 5 wt% of carbon nanotubes; and a balance of the dispersion medium, based on the total weight of the composition.

7. The carbon nanotube composition according to claim 5 or 6, wherein a weight ratio of the carbon nanotube to the dispersant is in an amount of 1:0.001 to 1:10.

8. The carbon nanotube composition according to claim 5, wherein the carbon nanotube is one or more selected from the group consisting of a single-walled nanotube, a double-walled nanotube, a multi-walled nanotubes, a bundled nanotubes, or a mixture thereof.

9. The carbon nanotube composition according to any of claims 5 to 8, wherein the organic solvent is one or more selected from the group consisting of alcohols, including methylalcohol, ethylalcohol, n-propylalcohol, isopropylalcohol, n-butylalcohol, sec-butylalcohol, t-butylalcohol, iso-butylalcohol, and diacetone alcohol; ketones, including acetone, methylethylketone, and methylisobutylketone; glycols, including ethyleneglycol, diethyleneglycol, triethyleneglycol, propyleneglycol, butyleneglycol, hexyleneglycol, 1,3-propanediol, 1,4-butanediol, 1,2,4-butanetriol, 1,5-pentanediol, 1,2-hexanediol, and 1,6-hexanediol; glycol ethers including ethyleneglycol monomethyl ether, and triethyleneglycol monoethyl ether; glycol ether acetates including propyleneglycol monomethyl ether acetate (PGMEA); acetates including ethylacetate, butoxyethoxy ethyl acetate, butyl carbitol acetate (BCA), and dihydroterpineol acetate (DHTA); terpineols; trimethyl pentanediol monoisobutyrate (TEXANOL); dichloroethene (DCE); 1-methyl pyrrolidone (NMP), or a combination comprising at least one of the foregoing solvents.

10. The carbon nanotube composition according to any of claims 5 to 9, wherein the composition further comprises one or more additives selected from the group consisting of an organic binder, a photosensitive monomer, a photoinitiator, a viscosity modifier, a storage stabilizer, a wetting agent, and an acid or a base.

11. The carbon nanotube composition according to claim 10, wherein an amount of the additive is 0.1 to 60 parts by weight, based on 100 parts by weight of the composition.

12. The carbon nanotube composition according to claim 10 or 11, wherein the organic binder is one or more selected from the group consisting of celluloses, including ethylcellulose, styrenes, a styrene-acrylic acid ester copolymer, polyvinylbutyral, polyvinylalcohol, and polypropylene carbonate.

13. A method comprising:
blending a dispersant according to any of claims 1-4; carbon nanotubes; and a dispersion medium selected from the group consisting of an organic solvent, water, and a mixture thereof.

14. The method of Claim 13, wherein the blending comprises melt blending or solution blending.

15. The method of Claim 14, wherein the blending is conducted in an extruder.

## Patentansprüche

1. Dispersionsmittel für Kohlenstoffnanoröhrchen, das Folgendes umfasst:
einen kovalent an einen Schwanz gebundenen Kopf,
wobei der Kopf einen aromatischen Ring hat, wobei die Schwänze regioreguläre angeordnet sind und wobei der Kopf aus einer Gruppe ausgewählt wird, die durch die folgende Formel (1) dargestellt wird und der Schwanz aus einer Gruppe ausgewählt wird, die durch die folgende Formel (2) dargestellt wird: 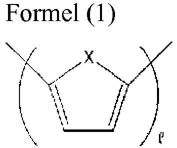 wobei
X S, NH oder O ist und
ℓ ein ganzzahliger Wert von 1 bis 60 ist,
Formel (2) (̵YOₐ)̵ₘ-(CH₂)ₙ-Z
wobei Y aus der Gruppe ausgewählt wird, die sich aus einer substituierten oder unsubstituierten Alkylengruppe aus 1 bis 10 Kohlenstoffatomen, einer substituierten oder unsubstituierten Alkenylengruppe aus 1 bis 10 Kohlenstoffatomen, einer substituierten oder unsubstituierten Alkynylengruppe aus 1 bis 10 Kohlenstoffatomen und einer substituierten oder unsubstituierten Arylalkylengruppe aus 6 bis 20 Kohlenstoffatomen zusammensetzt,
Z aus der Gruppe ausgewählt wird, die sich aus -H, -CH₃, -OH, Carboxylsäure oder Salzen davon, Schwefelsäure oder Salzen davon und Phosphorsäure oder Salzen davon zusammensetzt,
a gleich 0 oder 1 ist,
m ein ganzzahliger Wert von 1 bis 9 ist und
n ein ganzzahliger Wert von bis zu 9 ist,
wobei das Verhältnis der Anzahl der Köpfe zur Anzahl der Schwänze in dem Dispersionsmittel 2 zu 3 ist.

2. Dispersionsmittel nach Anspruch 1, wobei in der Formel (1) X S ist.

3. Dispersionsmittel nach Anspruch 1 oder 2, wobei in der Formel (1) ℓ ein ganzzahliger Wert von 10 bis 20 ist.

4. Dispersionsmittel nach Anspruch 1 bis 3, wobei der Schwanz Polyethylenoxid mit 3 bis 20 Kohlenstoffatomen oder Polypropylenoxid mit 4 bis 20 Kohlenstoffatomen ist.

5. Kohlenstoffnanoröhrchen-Zusammensetzung, die Folgendes umfasst:
das Dispersionsmittel nach einem der Ansprüche 1 bis 4,
Kohlenstoffnanoröhrchen und
ein Dispersionsmedium, das aus einer Gruppe ausgewählt wird, die sich aus einem organischen Lösungsmittel, Wasser und einer Mischung davon zusammensetzt.

6. Kohlenstoffnanoröhrchen-Zusammensetzung nach Anspruch 5, wobei die Zusammensetzung 0,001 bis 10 Gew.-% eines Dispersionsmittels, 0,01 bis 5 Gew.-% Kohlenstoffnanoröhrchen und einen Rest Dispersionsmedium, ausgehend von dem Gesamtgewicht der Zusammensetzung, umfasst.

7. Kohlenstoffnanoröhrchen-Zusammensetzung nach Anspruch 5 oder 6, wobei ein Gewichtsverhältnis der Kohlenstoffnanoröhrchen zu dem Dispersionsmittel in einem Bereich zwischen 1:0,001 und 1:10 liegt.

8. Kohlenstoffnanoröhrchen-Zusammensetzung nach Anspruch 5, wobei das Kohlenstoffnanoröhrchen einem oder mehreren aus einer Gruppe entspricht, die sich aus einwandigen Nanoröhrchen, doppelwandigen Nanoröhrchen, mehrwandigen Nanoröhrchen oder einer Mischung daraus zusammensetzt.

9. Kohlenstoffnanoröhrchen-Zusammensetzung nach einem der Ansprüche 5 bis 8, wobei das organische Lösungsmittel einem oder mehreren aus der Gruppe entspricht, die sich aus Alkoholen zusammensetzt, einschließlich Methylalkohol, Ethylalkohol, n-Propylalkohol, Isopropylalkohol, n-Butylalkohol, sec-Butylalkohol, t-Butylalkohol, Isobutylalkohol und Diacetonalkohol; Ketonen, einschließlich Aceton, Methylethylketon und Methylisobutylketon; Glykolen, einschließlich Ethylenglykol, Diethylenglykol, Triethylenglykol, Propylenglykol, Butylenglykol, Hexylenglykol, 1,3-Propandiol, 1,4-Butandiol, 1,2,4-Butantriol, 1,5-Pentandiol, 1,2-Hexandiol und 1,6-Hexandiol; Glykolethern einschließlich Ethylenglykolmonomethylether und Triethylenglykolmonoethylether; Glykoletheracetaten einschließlich Propylenglykolmonomethyletheracetat (PGMEA); Acetaten einschließlich Ethylacetat, Butoxyethoxyethylacetat, Butylcarbitolacetat (BCA) und Dihydroterpineolacetat (DHTA); Terpineolen; Trimethylpentandiolmonoisobutyrat (TEXANOL); Dichlorethen (DCE); 1-Methylpyrrolidon (NMP), oder einer Kombination, die mindestens eines der vorstehenden Lösungsmittel umfasst.

10. Kohlenstoffnanoröhrchen-Zusammensetzung nach einem der Ansprüche 5 bis 9, wobei die Zusammensetzung weiter ein oder mehrere Zusatzmittel umfasst, die aus einer Gruppe ausgewählt werden, welche sich aus einem organischen Binder, einem fotoempfindlichen Monomer, einem Fotoinitiator, einem Viskositätsmodifikator, einem Stabilisator für die Lagerung, einem Benetzungsmittel und einer Säure oder einer Base zusammensetzt.

11. Kohlenstoffnanoröhrchen-Zusammensetzung nach Anspruch 10, wobei der Gehalt des Zusatzmittels zwischen etwa 0,1 und 60 Gewichtsanteilen, basierend auf 100 Gewichtsanteil der Zusammensetzung, liegt.

12. Kohlenstoffnanoröhrchen-Zusammensetzung nach Anspruch 10 oder 11, wobei der organische Binder einem oder mehreren aus einer Gruppe entspricht, die sich aus Cellulosen, einschließlich Ethylcellulose, Styrenen, einem Styren-Acrylsäureester-Copolymer, Polyvinylbutyral, Polyvinylalkohol und Polypropylencarbonat zusammensetzt.

13. Verfahren, Folgendes umfassend:
Vermischen eines Dispersionsmittels nach einem der Ansprüche 1-4, Kohlenstoffnanoröhrchen und eines Dispersionsmediums aus der Gruppe, die aus einem organischen Lösungsmittel, Wasser und einer Mischung davon besteht.

14. Verfahren nach Anspruch 13, wobei das Vermischen das Vermischen in der Schmelze oder das Vermischen in der Lösung umfasst.

15. Verfahren nach Anspruch 14, wobei das Vermischen in einem Extruder erfolgt.

## Revendications

1. Dispersant pour nanotubes en carbone, comprenant :
une tête liée par covalence à une queue ;
la tête comportant un noyau aromatique ; lesdites queues étant régiorégulièrement agencées, et ladite tête étant choisie dans le groupe représenté par la formule (1) suivante, et ladite queue étant choisie dans le groupe représenté par la formule (2) suivante : 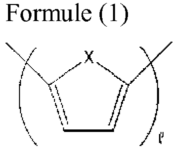 dans laquelle
X représente un atome S, un groupe NH ou un atome O, et
t représente un entier de 1 à 60,
Formule (2) (̵YOₐ)̵ₘ-(CH₂)ₙ-Z
dans laquelle Y est choisi dans le groupe constitué par un groupe alkylène substitué ou non substitué de 1 à 10 atomes de carbone, un groupe alcénylène substitué ou non substitué de 1 à 10 atomes de carbone, un groupe alcynylène substitué ou non substitué de 1 à 10 atomes de carbone, et un groupe arylalkylène substitué ou non substitué de 6 à 20 atomes de carbone,
Z est choisi dans le groupe constitué par l'atome -H, le groupe -CH₃, -OH, acide carboxylique ou les sels de celui-ci, acide sulfonique ou les sels de celui-ci, et acide phosphorique ou les sels de celui-ci,
a est égal à 0 ou 1,
m représente un entier de 1 à 9, et
n représente un entier allant jusqu'à 9,
ledit rapport du nombre de têtes sur le nombre de queues dans le dispersant étant de 2 sur 3.

2. Dispersant selon la revendication 1, dans lequel, dans la formule (1), X représente un atome S.

3. Dispersant selon la revendication 1 ou 2, dans lequel, dans la formule (1), t représente un entier de 10 à 20.

4. Dispersant selon l'une quelconque des revendications 1 à 3, ladite queue étant l'oxyde de polyéthylène comportant 3 à 20 atomes de carbone ou l'oxyde de polypropylène comportant de 4 à 20 atomes de carbone.

5. Composition de nanotubes de carbone comprenant :
le dispersant selon l'une quelconque des revendications 1 à 4 ;
des nanotubes de carbone ; et
un milieu de dispersion choisi dans le groupe constitué par un solvant organique, l'eau et un mélange de ceux-ci.

6. Composition de nanotubes de carbone selon la revendication 5, ladite composition comprenant 0,001 à 10 % en poids de dispersant ; 0,01 à 5 % en poids de nanotubes de carbone ; et le reste étant le milieu de dispersion, sur la base du poids total de la composition.

7. Composition de nanotubes de carbone selon la revendication 5 ou 6, le rapport massique des nanotubes de carbone sur le dispersant étant en une quantité de 1:0,001 à 1:10.

8. Composition de nanotubes de carbone selon la revendication 5, ledit nanotube de carbone étant un ou plusieurs nanotubes choisis dans le groupe constitué par un nanotube à simple paroi, un nanotube à double paroi, un nanotube à parois multiples, des nanotubes groupés, ou un mélange de ceux-ci.

9. Composition de nanotubes de carbone selon l'une quelconque des revendications 5 à 8, ledit solvant organique étant un ou plusieurs solvants choisis dans le groupe constitué par les alcools, dont l'alcool méthylique, l'alcool éthylique, l'alcool n-propylique, l'alcool isopropylique, l'alcool n-butylique, l'alcool sec-butylique, l'alcool t-butylique, l'alcool isobutylique et l'alcool diacétonique ; les cétones, dont l'acétone, la méthyléthylcétone et la méthylisobutylcétone ; les glycols, dont l'éthylèneglycol, le diéthylèneglycol, le triéthylèneglycol, le propylèneglycol, le butylèneglycol, l'hexylèneglycol, le 1,3-propanediol, le 1,4- butanediol, le 1,2,4-butanetriol, le 1,5-pentanediol, le 1,2-hexanediol, et le 1,6-hexanediol ; les éthers glycoliques dont l'éther monométhylique d'éthylèneglycol, et l'éther monoéthylique de triéthylèneglycol ; les acétates d'éthers glycoliques dont l'acétate d'éther monométhylique de propylèneglycol (PGMEA) ; les acétates dont l'acétate d'éthyle, l'acétate de butoxyéthoxyéthyle, l'acétate de butylcarbitol (BCA), et l'acétate de dihydroterpinéol (DHTA) ; les terpinéols ; le monoisobutyrate de triméthylpentanediol (TEXANOL) ; le dichloroéthène (DCE) ; la 1-méthylpyrrolidone (NMP), ou une combinaison comprenant au moins l'un des solvants précédents.

10. Composition de nanotubes de carbone selon l'une quelconque des revendications 5 à 9, ladite composition comprenant en outre un ou plusieurs additifs choisis dans le groupe constitué par un liant organique, un monomère photosensible, un photoinitiateur, un modificateur de viscosité, un stabilisant au stockage, un agent mouillant, et un acide ou une base.

11. Composition de nanotubes de carbone selon la revendication 10, la quantité de l'additif représentant 0,1 à 60 parties en poids, sur la base de 100 parties en poids de la composition.

12. Composition de nanotubes de carbone selon la revendication 10 ou 11, ledit liant organique étant un ou plusieurs liants organiques choisis dans le groupe constitué par les celluloses, dont l'éthylcellulose, les styrènes, un copolymère styrène-ester d'acide acrylique, le polyvinylbutyral, l'alcool polyvinylique et le carbonate de polypropylène.

13. Procédé comprenant :
le mélange d'un dispersant selon l'une quelconque des revendications 1 à 4 ; de nanotubes de carbone ; et d'un milieu de dispersion choisi dans le groupe constitué par un solvant organique, l'eau, et un mélange de ceux-ci.

14. Procédé selon la revendication 13, ledit mélange comprenant le mélange à l'état fondu ou le mélange en solution.

15. Procédé selon la revendication 14, ledit mélange étant effectué dans une extrudeuse.
